(19) Europäisches Patentamt
European Patent Office
Office européen des brevets

(11) **EP 4 697 601 A1**

(12) **EUROPÄISCHE PATENTANMELDUNG**

(43) Veröffentlichungstag:
**18.02.2026 Patentblatt 2026/08**

(21) Anmeldenummer: 24194464.4

(22) Anmeldetag: **14.08.2024**

(51) Internationale Patentklassifikation (IPC):
**H03K 17/12** (2006.01) **H03K 17/687** (2006.01)

(52) Gemeinsame Patentklassifikation (CPC):
**H03K 17/12; H03K 17/6871;** H03K 2217/0036;
H03K 2217/0063; H03K 2217/0072;
H03K 2217/0081

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(71) Anmelder: **Hilti Aktiengesellschaft
9494 Schaan (LI)**

(72) Erfinder:
• **Hurka, Florian
86459 Margertshausen (DE)**
• **Scherbaum, Markus
86853 Gennach (DE)**

(74) Vertreter: **Hilti Aktiengesellschaft
Corporate Intellectual Property
Feldkircherstrasse 100
Postfach 333
9494 Schaan (LI)**

(54) **ANTRIEBSEINHEIT FÜR EINE HANDWERKZEUGMASCHINE UND HANDWERKZEUGMASCHINE**

(57) Es wird eine Antriebseinheit für eine Handwerkzeugmaschine vorgeschlagen. Die Antriebseinheit aufweisend: eine Spannungsquelle zum Bereitstellen einer ausgangsseitigen Gleichspannung; einen Elektromotor, der durch die ausgangsseitige Gleichspannung betreibbar ist; und eine Schalteinrichtung, die zwischen der Spannungsquelle und dem Elektromotor geschaltet ist, und durch die die ausgangsseitige Gleichspannung zum Steuern des Elektromotors schaltbar ist, wobei die Schalteinrichtung mindestens einen ersten Schalter und einen zweiten Schalter, der parallel zu dem ersten Schalter geschaltet ist, aufweist, wobei der erste Schalter ein erstes Halbleitermaterial aufweist, wobei der zweite Schalter ein zweites Halbleitermaterial aufweist, und wobei sich das erste Halbleitermaterial von dem zweiten Halbleitermaterial unterscheidet.

Fig. 3

EP 4 697 601 A1

**Beschreibung**

GEBIET DER ERFINDUNG

Die vorliegende Erfindung betrifft eine Antriebseinheit für eine Handwerkzeugmaschine und eine Handwerkzeugmaschine mit einer solchen Antriebseinheit.

Eine Schalteinrichtung zum Betreiben eines elektrischen Motors in einer Handwerkzeugmaschine wird mit einer Gleichspannung versorgt, die oftmals von einer Batterie oder einem Gleichrichter bereitgestellt wird.

Widebandgap-Halbleiter, wie Gallium-Nitrid (GaN) High Electron Mobility Transistoren (HEMTs), haben in den letzten Jahren zunehmend an Popularität gewonnen. Ein wesentlicher Grund für die steigende Nachfrage ist ihre Fähigkeit, mit höheren Frequenzen an- und auszuschalten, ohne dabei signifikante Verluste zu erzeugen. Jeder Schaltvorgang, sei es das Ein- oder Ausschalten von Spannung oder Strom, verursacht nämlich Verluste. Je schneller die Schaltfrequenz, desto größer sind diese Verluste.

Wenn ein Transistor aktiviert wird, beginnt er zu leiten, wodurch die Spannung über dem Halbleiter gegen null geht, während der Strom zu fließen beginnt und ansteigt. Diese Schaltvorgänge geschehen nicht augenblicklich, sondern benötigen eine gewisse Zeit. Bei siliziumbasierten Metalloxid-Halbleiter-Feldeffekttransistoren (MOSFETs) oder Gate-isolierte Bipolar-Transistoren (IGBTs) liegen diese Schaltzeiten typischerweise im Bereich von 150 bis 1500 Nanosekunden. Im Gegensatz dazu können High-Electron-Mobility Transistoren (HEMTs) in weniger als 20 Nanosekunden ein- oder ausschalten.

Die Verlustleistung während des Schaltvorgangs berechnet sich aus dem Produkt von Strom und Spannung: $P_{switch} = U \times I$.

Neben dem Vorteil, schneller Schalten zu können, haben Gallium-basierte Transistoren auch Eigenschaften, die ihren Einsatz in Elektronikprodukten, insbesondere solchen, die in großen Stückzahlen hergestellt werden, erschweren. Einerseits sind solche Transistoren noch sehr teuer. Andererseits weisen diese Transistoren Leitverluste auf, nämlich insbesondere dann, wenn sie durchgeschaltet bzw. stromfördernd geschaltet sind.

Es besteht also insbesondere für Schalteinrichtungen zur Steuerung eines elektrischen Motors in einer Handwerkzeugmaschine noch Entwicklungspotenzial, um Schaltverluste weiter zu minimieren.

Vor diesem Hintergrund besteht die Aufgabe der vorliegenden Erfindung, eine verbesserte Antriebseinheit für eine Handwerkzeugmaschine und/oder eine verbesserte Handwerkzeugmaschine zu schaffen.

OFFENBARUNG DER ERFINDUNG

Gemäß einem ersten Aspekt wird eine Antriebseinheit für eine Handwerkzeugmaschine vorgeschlagen. Die Antriebseinheit weist eine Spannungsquelle (auch Hauptversorgung der Antriebseinheit genannt) zum Bereitstellen einer ausgangsseitigen Gleichspannung, einen Elektromotor, der durch die ausgangsseitige Gleichspannung betreibbar ist, und eine Schalteinrichtung auf. Die Schalteinrichtung ist zwischen der Spannungsquelle und dem Elektromotor geschaltet. Die Schalteinrichtung ist ferner dazu eingerichtet, die ausgangsseitige Gleichspannung zum Steuern des Elektromotors zu schalten. Die Schalteinrichtung weist mindestens einen ersten Schalter und einen zweiten Schalter, der parallel zu dem ersten Schalter geschaltet ist, auf. Der erste Schalter weist ein erstes Halbleitermaterial auf. Der zweite Schalter weist ein zweites Halbleitermaterial auf. Das erste Halbleitermaterial unterscheidet sich von dem zweiten Halbleitermaterial.

Die vorliegende Schalteinrichtung ist aufgrund des Einsatzes der mindestens zwei Schalter, die sich hinsichtlich ihres Halbleitermaterials unterscheiden, kostengünstig und damit in großen Stückzahlen herstellbar. Es kann beispielsweise mindestens ein Schalter verwendet werden, der ein Halbleitermaterial, insbesondere ein Widebandgap-Halbleitermaterial, aufweist, das ein besonders schnelles bzw. hochfrequentes Schalten ermöglicht. Andererseits kann mindestens ein anderer Schalter verwendet werden, der ein Halbleitermaterial aufweist, das gegenüber dem schnellschaltenden Schalter geringere Leitverluste besitzt und in der Regel selbst nur für geringere Schaltfrequenzen geeignet ist. So können die Vorteile des hochfrequent schaltbaren Schalters (geringe Schaltverluste) mit den Vorteilen des parallelen Schalters (geringe Leitverluste) kombiniert werden, was insgesamt in einer kostengünstigen und effizienten bzw. verlustarmen Schalteinrichtung resultiert, die gesamthaft, insbesondere aufgrund der Parallelschaltung der mindestens zwei Schalter, eine gesamthaft hohe Schaltfrequenz und Effizienz ermöglicht. Ferner kann durch den Einsatz des niedrig-frequent schaltbaren Schalters ein optimierter Leitwert für die Schalteinrichtung realisiert werden.

Durch die vorliegende Schalteinrichtung können somit zugleich Durchlassverluste und Schaltverluste minimiert werden. Dies wird ermöglicht, indem mindestens zwei Schalter mit unterschiedlichen Halbleitertypen und somit Halbleitereigenschaften eingesetzt, in einer Hybridschaltung vereint und zueinander parallelgeschaltet werden. Die vorgeschlagene Hybridschaltung verbindet somit die Vorteile von zwei sich unterscheidenden, halbleiterbasierten Schaltertypen. Im Gegensatz zu einer reinen hochfrequent schaltenden Schaltung, die beispielsweise nur Widebandgap-Halbleiter-basierte Schalter, wie Gallium-Nitrid (GaN)-basierte Transistoren, aufweist, kann/können somit z.B. die Anzahl der parallel arbeitenden Schalter, insbesondere Transistoren, reduziert und/oder kostengünstigere Schalter-Typen eingesetzt werden.

Die vorliegende Schalteinrichtung kann beispielsweise eine Leistungselektronik der Antriebseinheit ausbilden. Die Schaltereinrichtung kann zumindest Teil eines Motorinverters und/oder einer Motoransteuerung und/oder eines DC/DC-Wandlers und/oder eines AC/DC-Wandlers sein.

Gemäß einem zweiten Aspekt wird eine Handwerkzeugmaschine mit einer derartigen Antriebseinheit vorgeschlagen.

Die Handwerkzeugmaschine ist vorzugsweise als eine Bohrmaschine, ein Schlagbohrer, ein Bohrhammer, eine Handkreissäge, eine Stichsäge, eine Säbelsäge, ein Trennschleifer, ein Rührwerk oder dergleichen ausgebildet. Bevorzugt kann die Handwerkzeugmaschine bzw. das Elektrowerkzeug akkubetrieben sein und einen oder mehrere, insbesondere auch wechselbare, Akkus, beispielsweise eine Lithium-Ionen-Batterie, aufweisen.

Die für die Antriebseinheit gemachten Ausführungen gelten für die Handwerkzeugmaschine entsprechend und umgekehrt.

In einer Ausführungsform wird vorgeschlagen, dass der erste Schalter einen Gate-Terminal-Transistor, insbesondere einen Metalloxid-Halbleiter-Feldeffekttransistor, aufweist, und/oder wobei der zweite Schalter einen 3-Terminal-Transistor, insbesondere einen High-Electron-Mobility Transistor, aufweist, und/oder wobei das erste Halbleitermaterial Silizium-basiert ist, und/oder wobei das zweite Halbleitermaterial Gallium-basiert ist.

Grundsätzlich sind auch andere, halbleiterbasierte Transistortypen, wie Gate-isolierte Bipolar-Transistoren (IGBTs), einsetzbar.

Ein 3-Terminal-Transistor ist vorzugsweise ein elektronisches Bauelement, das drei Anschlüsse (Terminals) aufweist und zur Steuerung elektrischer Ströme verwendet wird. Die drei Anschlüsse umfassen ein Gate (G), das den Steueranschluss, über den die Leitfähigkeit des Transistors gesteuert wird, ausbildet, eine Source (S), die den Anschluss, durch den der Strom in den Transistor eintritt, ausbildet, und einen Drain (D), der den Anschluss, durch den der Strom den Transistor verlässt, ausbildet. Diese drei Terminals erlauben es, den Stromfluss zwischen Source und Drain durch eine Spannung oder einen Strom am Gate zu kontrollieren. Die spezifische Funktionsweise hängt dabei vom Typ des Transistors ab. Bei dem Metalloxid-Halbleiter-Feldeffekttransistor (MOSFET) steuert die Spannung am Gate die Leitfähigkeit zwischen Source und Drain. Bei dem High-Electron-Mobility Transistor (HEMT) werden Halbleitermaterialien mit hoher Elektronenbeweglichkeit (z.B. Gallium-Nitrid) verwendet. Die 3-Terminal-Konfiguration ermöglicht es, den Transistor als Schalter zu verwenden.

Die Fähigkeit Gallium-basierter Schalter, schnell (d.h., gleich oder kleiner als 20 Nanosekunden) schalten zu können und dabei geringere Schaltverluste zu erzeugen, macht sie besonders attraktiv für Anwendungen, bei denen eine hohe Schalteffizienz und Schaltleistung entscheidend sind, wie beispielsweise der vorliegenden Antriebseinheit. Die Gallium-basierten Schalter ermöglichen es nämlich im Vergleich zu Siliziumbasierten Schaltern wesentlich schneller und schaltverlustärmer zu schalten. Somit besteht für die Implementierung hoher Schaltfrequenzen nahezu keine Limitierung mehr.

Ein Gallium-basierter Schalter weist zwar (im durchgeschalteten Zustand) höhere Leitverluste auf. Dieser Nachteil wird allerdings vorliegend durch den Einsatz eines Silizium-basierten Schalters, der parallel zu dem Gallium-basierter Schalter geschaltet ist, kompensiert. Diese Silizium-basierten Schalter ermöglichen zwar nur ein langsameres Schalten, zum Beispiel im Bereich von 150 bis 1500 Nanosekunden, weisen dafür aber eine hohe Leitfähigkeit auf, durch die die Leitverluste der Schalteinrichtung minimiert werden können. Das vergleichsweise langsame Schalten des Siliziumbasierten Schalters hat vorliegend somit keinen nachteiligen Effekt auf die Performance der Schalteinrichtung, da dieser Faktor durch die Schnellschaltfähigkeit des Gallium-basierten Schalters, insbesondere durch geeignete Wahl der Schalttaktung bzw. der Schaltzeitpunkte des jeweiligen Schalters, kompensierbar ist.

In einer Ausführungsform wird vorgeschlagen, dass der erste Schalter und der zweite Schalter der Schalteinrichtung in mindestens einer Halbbrücken-Schaltung oder einer Lowside-Schaltung oder einer Highside-Schaltung umfasst sind.

Die Schalteinrichtung kann vorliegend auch mehrere Halbbrücken-Schaltungen oder mehrere Lowside-Schaltungen oder mehrere Highside-Schaltungen aufweisen. Eine solche Halbbrücken-Schaltung weist vorzugsweise mindestens zwei erste Schalter und mindestens zwei zweite Schalter auf. Mit anderen Worten weist die Halbbrücken-Schaltung vorzugsweise mindestens zwei Schalter, die auf dem ersten Halbleitermaterial basieren, und mindestens zwei Schalter, die auf dem zweiten Halbleitermaterial basieren, auf. Die Halbbrücken-Schaltung ist eine Konfiguration, bei der mindestens zwei erste Schalter in Serie geschaltet und zwei zweite Schalter ebenfalls in Serie und parallel zu den zwei ersten Schaltern geschaltet sind. Ferner existiert mindestens ein gemeinsamer Verbindungspunkt, der als Ausgang, insbesondere zu einer Last, beispielsweise dem Elektromotor, dient. Diese Konfiguration wird bevorzugt in Wechselrichtern und Leistungswandlern verwendet. Die Lowside-Schaltung ist eine Konfiguration, bei der der zweite Schalter zwischen der Last und der Masse (Erde) geschaltet ist. Diese Anordnung schaltet die Last zur Masse hin. Die Highside-Schaltung ist eine Konfiguration, bei der der zweite Schalter zwischen der Spannungsquelle und der Last geschaltet ist. Diese Anordnung schaltet die Last zur Spannungsquelle hin und ist bevorzugt, wenn die Last auf ein höheres Potential geschaltet werden soll.

In einer Ausführungsform wird vorgeschlagen, dass die Antriebseinheit ferner eine Schaltersteuereinrichtung aufweist, die dazu eingerichtet ist, eine Schalttaktung zum Schalten des ersten Schalters und eine Schalttaktung zum Schalten des zweiten Schalters jeweils individuell zu steuern.

Durch ein unterschiedliches Ansteuertiming bzw. die unterschiedliche Schalttaktung kann der schnellschaltende und schaltverlustarme zweite Schalter vorzugsweise die Schaltvorgänge der Schalteinrichtung übernehmen, und derart die Schaltverluste minimieren. Andererseits kann der leitverlustarme erste Schalter, der vorzugsweise zur Leistungsbereitstellung zeitlich nach dem zweiten Schalter eingeschaltet wird, für dem Energiefluss bzw. Stromfluss verwendet werden, um derart auch die Leitverluste der Schalteinrichtung zu minimieren. Um das unterschiedliche Ansteuertiming zu realisieren bzw. um die Schalter individuell zu ein- und auszuschalten, wird bevorzugt die Schaltersteuereinrichtung verwendet. Die Schaltersteuereinrichtung kann beispielsweise als eine μC-Ansteuerung, die Treiber der Schalter unabhängig steuern kann, ausgebildet sein. Die Schaltersteuereinrichtung kann auch durch mindestens einen Hardware-Verzögerungsblock ausgebildet sein.

In einer Ausführungsform wird vorgeschlagen, dass die Schaltersteuereinrichtung dazu ausgebildet ist, die Schalttaktung des zweiten Schalters zeitlich vor der Schalttaktung des ersten Schalters zu steuern, und/oder die Schalttaktung des ersten Schalters zeitlich vor der Schalttaktung des zweiten Schalters zu steuern.

Zur Energiebereitstellung an den Elektromotor bzw. zum Einschalten kann der zweite Schalter vorzugsweise um einen durch die Schaltfrequenz des zweiten Schalters festgelegten Einschaltzeitpunkt vor dem ersten Schalter eingeschaltet werden. Somit werden die Einschaltverluste vom zweiten Schalter übernommen. Der erste Schalter wird vorzugsweise erst dann zugeschaltet, wenn der zweite Schalter den vollen Strom leitet und die Spannung über den zweiten Schalter und den ersten Schalter nahe 0 ist. Somit kann der erste Schalter verlustfrei geschaltet werden (sog. Zero Voltage Switching).

Zum Abschalten kann der zweite Schalter vorzugsweise um einen durch die Schaltfrequenz des zweiten Schalters festgelegten Ausschaltzeitpunkt nach dem ersten Schalter ausgeschaltet werden. Somit werden die Schaltverluste vom zweiten Schalter übernommen. Der erste Schalter wird bereits ausgeschaltet, wenn der zweite Schalter noch eingeschaltet bzw. noch leitend ist und noch Strom führt. Die Spannung über den zweiten Schalter und den ersten Schalter ist somit nahe 0. Somit kann der erste Schalter verlustfrei ausgeschaltet werden.

Die Gesamtverluste der Schalteinrichtung werden somit effektiv minimiert.

In einer Ausführungsform wird vorgeschlagen, dass das erste Halbleitermaterial einen Bandabstand bzw. eine Bandlücke von kleiner 2,0 Elektronenvolt (eV) aufweist, und dass das zweite Halbleitermaterial einen Bandabstand bzw. eine Bandlücke von größer gleich 2,0 Elektronenvolt (eV) aufweist.

Der Bandabstand (auch als Bandlücke bezeichnet) ist vorzugsweise die Energie, die erforderlich ist, um ein Elektron aus dem Valenzband in das Leitungsband eines Halbleitermaterials zu fördern. Als Halbleitermaterialien kommen beispielsweise Beta-Galliumoxid ($\beta$-Ga$_2$O$_3$), Gallium-Nitrid (GaN) oder Siliziumkarbid (SiC) zum Einsatz. Beta-Galliumoxid ($\beta$-Ga$_2$O$_3$) hat einen Bandabstand von etwa 4,8 bis 4,9 eV. Beta-Galliumoxid ist ein ultrabreitbandiger Halbleiter, der für Hochspannungs- und Hochleistungselektronik verwendet wird. Gallium-Nitrid (GaN) hat einen Bandabstand von etwa 3,4 eV. Gallium-Nitrid ist ein Halbleiter für Hochfrequenz- und Hochleistungselektronik. Siliziumkarbid (SiC) hat einen Bandabstand von etwa 2,3 bis 3,3 eV, abhängig von der Polytypstruktur (z.B. 4H-SiC, 6H-SiC). Siliziumkarbid ist bekannt für seine hervorragende thermische und elektrische Leistung und wird häufig in Schalteinrichtung und Hochtemperaturanwendungen verwendet. Diese Materialien bieten eine hohe Effizienz und Stabilität unter extremen Bedingungen.

In einer Ausführungsform wird vorgeschlagen, dass die Spannungsquelle durch mindestens zwei Kontakte, die mit mindestens einer Akkueinheit verbindbar sind, bereitgestellt ist.

Die Spannungsquelle ist vorzugsweise dazu ausgebildet, eine Gleichspannung (DC) zu liefern. Die Spannungsquelle bildet vorzugsweise einen wesentlichen Bestandteil der Antriebseinheit und wird zur Energieversorgung des Elektromotors verwendet. Die Spannungsquelle weist vorzugsweise mindestens zwei oder mehr Kontakte bzw. Kontaktpunkte auf. Diese Kontakte sind vorzugsweise Verbindungspunkte, über die die elektrische Energie von der Akkueinheit an die Antriebseinheit übertragen wird. Die Kontakte der Spannungsquelle sind vorzugsweise so gestaltet, dass sie mit mindestens einer Akkueinheit verbunden werden können. Die Akkueinheit ist vorzugsweise ein wiederaufladbarer Energiespeicher, der elektrische Energie speichern und bei Bedarf wieder abgeben kann. Die Anordnung oder Konstruktion stellt sicher, dass die Spannungsquelle, durch die oben genannten Kontakte und deren Verbindungsmöglichkeiten mit der Akkueinheit, zuverlässig und effizient funktioniert.

In einer Ausführungsform wird vorgeschlagen, dass die Spannungsquelle ein Anschlussterminal aufweist, das einen AC/DC-Wandler umfasst, der dazu eingerichtet ist, eine netzseitige Wechselspannung in eine Gleichspannung umzuwandeln.

Bevorzugt kann die beanspruchte Schalteinrichtung auch zumindest ein Teil eines solchen AC/DC-Wandlers sein. Das Anschlussterminal ist vorzugsweise ein Verbindungs- oder Anschlusspunkt an der Spannungsquelle, über den die Spannungsquelle mit anderen Komponenten oder einer externen Energiequelle verbindbar ist. Der AC/DC-Wandler ist ein elektrisches Bauteil oder eine Schaltung, die dazu eingerichtet ist, eine Wechselspannung (AC) in eine Gleichspannung (DC) umzuwandeln. Der Wandler ist vorzugsweise in das Anschlussterminal integriert oder mit diesem verbunden. Eine netzseitige Wechselspannung ist vorzugsweise eine Wechselspannung, die von einem externen Stromnetz bereitgestellt wird, typischerweise mit standardisierten Spannungs- und Frequenzwerten (z.B. 230V, 50Hz in Europa).

KURZE BESCHREIBUNG DER FIGUREN

Die nachfolgende Beschreibung erläutert die Erfindung anhand von exemplarischen Ausführungsformen und Figuren. In den Figuren zeigt:

Fig. 1    eine schematische Ansicht einer akkubetriebenen Handwerkzeugmaschine;

Fig. 2    eine schematische Ansicht einer netzbetriebenen Handwerkzeugmaschine;

Fig. 3    eine schematische Ansicht einer Schalteinrichtung;

Fig. 4    eine schematische Ansicht einer Schalteinrichtung;

Fig. 5    eine schematische Ansicht einer Schalteinrichtung;

Fig. 6    ein schematisches Spannungs-Zeit-Diagramm zum Einschalten einer Schalteinrichtung; und

Fig. 7    ein schematisches Spannungs-Zeit-Diagramm zum Ausschalten einer Schalteinrichtung.

Gleiche oder funktionsgleiche Elemente werden durch gleiche Bezugszeichen in den Figuren indiziert, soweit nicht anders angegeben.

AUSFÜHRUNGSFORMEN DER ERFINDUNG

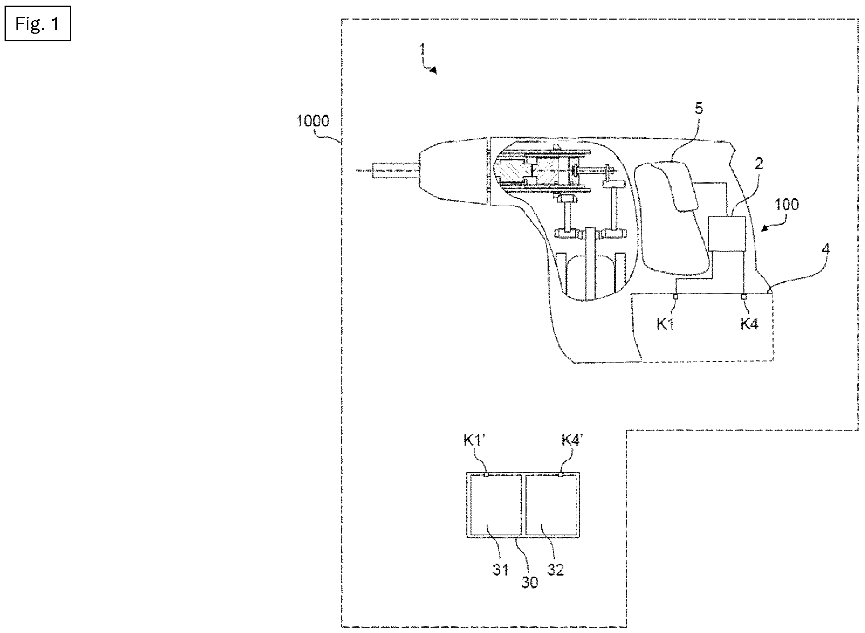

Fig. 1 zeigt eine schematische Ansicht einer akkubetriebenen Handwerkzeugmaschine 1, die hier als ein Schlagbohrer ausgeführt ist. Die Handwerkzeugmaschine 1 weist eine Aufnahmebucht 4 auf, die in diesem Beispiel zwei Kontakte K1, K4 aufweist. Die Aufnahmebucht 4 ist zum Aufnehmen einer Akkueinheit 30 eingerichtet. In jedem Fall werden die zwei Kontakte K1, K4 der Aufnahmebucht 4 mit zwei korrespondierenden Kontakten K1', K4' der Akkueinheit 30 in Kontakt gebracht.

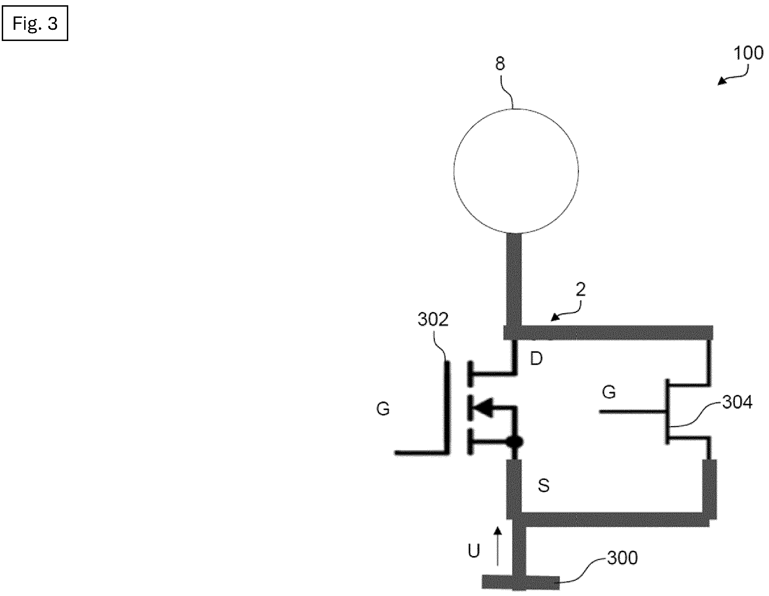

Zwischen den Kontakten K1 und K4 der Aufnahmebucht 4 ist ein Verbraucher der Handwerkzeugmaschine 1 geschaltet, insbesondere ein Elektromotor (in Fig. 1 ohne Bezugszeichen). In dem dargestellten Beispiel sind die Kontakte K1 und K4 mit einer Schalteinrichtung 2 verbunden, welche den Antriebsstrom für den Elektromotor schaltet. Die Schalteinrichtung 2 und der Elektromotor bilden einen Teil einer elektrischen Antriebseinheit 100, die gemäß verschiedenen Ausführungsbeispielen näher in den Fig. 3 bis 5 gezeigt ist.

Mit dem gestrichelten Kasten ist in der Fig. 1 rein beispielhaft ein System 1000 umfassend eine akkubetriebene Handwerkzeugmaschine 1 und eine Akkueinheit 30 mit mehreren Zellenanordnungen 31, 32 gekennzeichnet.

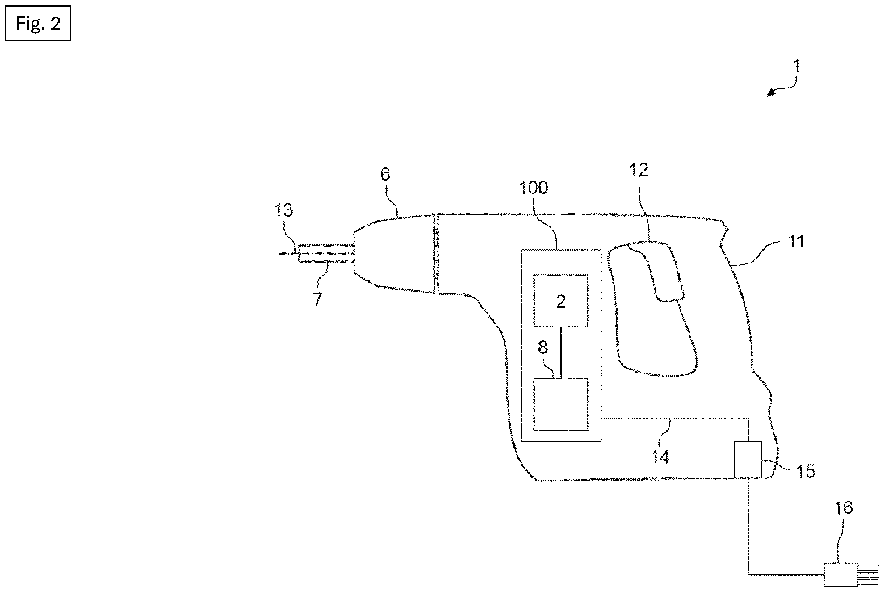

Fig. 2 zeigt eine schematische Ansicht eines weiteren Beispiels einer elektrischen Handwerkzeugmaschine 1, die beispielhaft als eine Bohrmaschine ausgebildet ist. Die Handwerkzeugmaschine 1 hat eine Werkzeugaufnahme 6, in welcher als ein Bohrwerkzeug 7 ein Bohrer eingesetzt ist. Ein Antrieb der Handwerkzeugmaschine 1 ist ein Elektromotor 8. Ein Bediener kann die Handwerkzeugmaschine 1 mittels eines Handgriffs 11 führen und mittels eines Tasters 12 in Betrieb nehmen. Im Betrieb dreht die Handwerkzeugmaschine 1 das Bohrwerkzeug 7, insbesondere, kontinuierlich um eine Arbeitsachse 13 und kann dabei das Bohrwerkzeug 7 längs der Arbeitsachse 13 in einen Untergrund hineinbohren.

Die Handwerkzeugmaschine 1 weist in Fig. 2 ein Ausführungsbeispiel der elektrischen Antriebseinheit 100 auf. Die elektrische Antriebseinheit 100 (siehe Ausführungsbeispiele in den Fig. 3 bis 5) umfasst den Elektromotor 8 und die Schalteinrichtung 2 zum Steuern des Elektromotors 8. Die elektrische Antriebseinheit 100 ist beispielhaft über eine elektrische Leitungsanordnung 14 mit einem Anschlussterminal 15 gekoppelt, welches mittels eines Steckers 16 mit einem Stromnetz (nicht gezeigt) gekoppelt werden kann. Alternativ kann die Handwerkzeugmaschine 1 auch über einen Akkumulator (wie in Fig. 1 gezeigt) mit Strom versorgt werden. Ein Antriebsstrang der Handwerkzeugmaschine 1 umfasst beispielsweise auch eine Antriebswelle und ein Getriebe zwischen dem Elektromotor 8 und der Antriebswelle (nicht gezeigt). Das Getriebe (nicht gezeigt) kann beispielsweise eine Drehzahl des Elektromotors 8 auf eine gewünschte Drehzahl des Bohrwerkzeuges 7 anpassen.

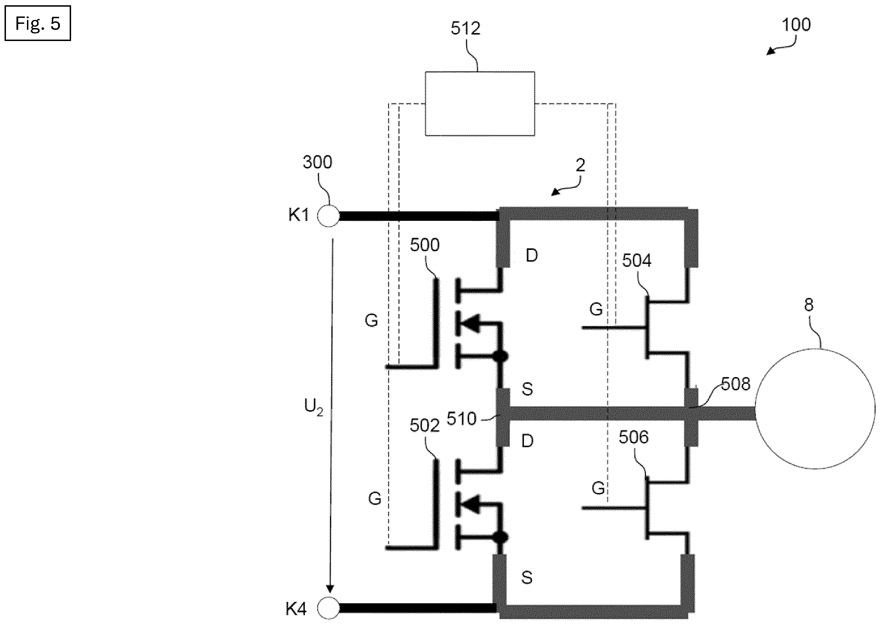

Fig. 3 bis 5 zeigen jeweils ein Ausführungsbeispiel der Antriebseinheit 100 der Handwerkzeugmaschine 1 im Detail. Die Antriebseinheit 100 umfasst eine Spannungsquelle 300. Die Spannungsquelle 300 kann am Beispiel von Fig. 1 und 5 durch eine zwischen den Kontakten K1 und K4 anliegende Gleichspannung U ausgebildet sein. Die Spannungsquelle 300 kann am Beispiel von Fig. 2, 3 und 4 alternativ durch das Anschlussterminal 15 ausgebildet sein, wobei in einem solchen Fall das Anschlussterminal 15 vorzugsweise einen AC/DC-Wandler (nicht näher gezeigt) umfassen kann, um eine netzseitige, über den Stecker 16 bereitgestellte Wechselspannung in die Gleichspannung U umzuwandeln.

Die eine Schalteinrichtung 2 ist zwischen der Spannungsquelle 300 und dem Elektromotor 8 geschaltet. Durch die Schalteinrichtung 2 ist die ausgangsseitige Gleichspannung U zum Steuern des Elektromotors 8 schaltbar.

Die Schalteinrichtung 2 umfasst mindestens einen ersten Schalter 302 und einen zweiten Schalter 304, der parallel zu dem ersten Schalter 302 geschaltet ist. Der erste Schalter 302 weist ein erstes Halbleitermaterial, am Beispiel der Fig. 3-5 ein Silizium-basiertes Halbleitermaterial, auf. Das erste Halbleitermaterial weist vorzugsweise einen Bandabstand bzw. eine Bandlücke kleiner 2,0 Elektronenvolt auf. Der erste Schalter 302 kann beispielsweise als ein Gate-Terminal-Transistor, insbesondere einen Metalloxid-Halbleiter-Feldeffekttransistor, ausgebildet sein.

Der zweite Schalter 304 weist ein zweites Halbleitermaterial, am Beispiel der Fig. 3-5 ein Gallium-basiertes Halbleitermaterial, auf. Das zweite Halbleitermaterial weist vorzugsweise einen Bandabstand bzw. eine Bandlücke von größer gleich 2,0 Elektronenvolt auf. Der zweite Schalter 304 kann beispielsweise als ein 3-Terminal-Transistor, insbesondere einen High-Electron-Mobility Transistor, ausgebildet sein. Das erste Halbleitermaterial unterscheidet sich vorliegend also von dem zweiten Halbleitermaterial, so dass der erste Schalter 302 und der zweite Schalter 304 unterschiedliche, halbleitermaterialbedingte Eigenschaften aufweisen.

Der erste Schalter 302 ist vorliegend im Vergleich zu dem zweiten Schalter 304 langsamer schaltend, d.h. die Schaltzeit ist länger. Die Schaltzeit des ersten Schalters 302 ist beispielsweise 120-150 Nanosekunden, wohingegen die Schaltzeit des zweiten Schalters 20 Nanosekunden sein kann. Der erste Schalter 302 weist vorliegend im Vergleich zu dem zweiten Schalter 304 eine höhere Leitfähigkeit für die Stromführung auf, so dass geringere Leitverluste verursacht werden, da gilt:

$$P_{Leitverlust} = U_{Schalter1} * I_{Schalter1} \sim 0\ W$$

Der zweite Schalter 304 weist vorliegend im Vergleich zu dem ersten Schalter 302 hingegen aufgrund der schnellschaltenden Eigenschaften geringere Schaltverluste auf, da gilt:

$$P_{Schaltverlust} = U_{Schalter2} * I_{Schalter2} \sim 0\ W$$

Der erste Schalter 302 umfasst vorliegend vorzugsweise mindestens ein Gate-Terminal G. Der zweite Schalter 304 umfasst vorliegend vorzugsweise drei Terminals, nämlich ein Gate-Terminal G, ein Source-Terminal S und ein Drain-Terminal D.

Gemäß Fig. 3 ist die Schalteinrichtung 2 als Lowside-Schaltung ausgebildet. Dies beschreibt eine Konfiguration, bei der der zweite Schalter 304 zwischen der Last und der Masse (Erde) geschaltet ist. Das Drain-Terminal D ist somit mit dem Elektromotor 8 (der Last) verbunden. Die Spannungsquelle 300 ist hingegen mit dem Source-Terminal S verbunden. Diese Anordnung schaltet die Last somit zur Masse hin.

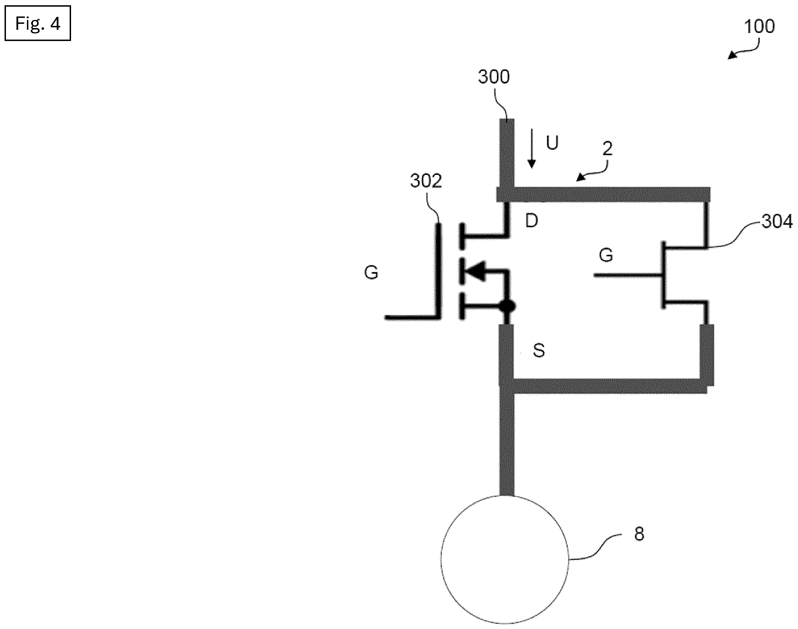

Gemäß Fig. 4 ist die Schalteinrichtung 2 als Highside-Schaltung ausgebildet. Dies beschreibt eine Konfiguration, bei der der zweite Schalter 304 zwischen der Spannungsquelle 300 und dem Elektromotor 8 geschaltet ist. Diese Anordnung schaltet die Last zur Spannungsquelle 300 hin und ist bevorzugt, wenn die Last auf ein höheres Potential geschaltet werden soll. Das Source-Terminal S ist somit mit dem Elektromotor 8 (der Last) verbunden. Die Spannungsquelle 300 ist hingegen mit dem Drain-Terminal D verbunden.

Fig. 5 zeigt die Schalteinrichtung 2 als Halbbrücken-Schaltung. Die Halbbrückenschaltung umfasst zwei erste Schalter 500, 502 und zwei zweite Schalter 504, 506. Die zwei ersten Schalter 500, 502 sind in Serie geschaltet, wobei zwischen den zwei ersten Schaltern 500, 502 ein Mittelabgriff 510 zum Elektromotor 8 hin vorgesehen ist. Die zwei zweiten Schalter 504, 506 sind in Serie geschaltet, wobei zwischen den zwei zweiten Schaltern 504, 506 ein Mittelabgriff 508 zum Elektromotor 8 hin vorgesehen ist. Die zwei ersten Schalter 500, 502 sind parallel zu den zwei zweiten Schaltern 504, 506 geschaltet.

Die Antriebseinheit 100 weist gemäß Fig. 5 beispielhaft eine Schaltersteuereinrichtung 512 auf, die dazu eingerichtet ist, eine Schalttaktung zum Schalten der ersten Schalter 500, 502 und eine Schalttaktung zum Schalten der zweiten Schalter 504, 506 jeweils individuell zu steuern. Die Schalteinrichtungen 2, wie sie in Fig. 3 und 4 gezeigt sind, können selbstredend eine entsprechende Schaltersteuereinrichtung aufweisen. Die Schaltersteuereinrichtung 512 ist vorliegend jeweils mit dem Gate-Terminal G des jeweiligen Schalters 500, 502, 504, 506 steuersignalübertragend verbunden.

Die Schaltersteuereinrichtung 512 ist dazu ausgebildet, die Schalttaktung der zweiten Schalter 504, 506 beim Einschaltvorgang zeitlich vor der Schalttaktung der parallelen ersten Schalter 500, 502 jeweils individuell zu steuern. Alternativ oder ergänzend ist die Schaltersteuereinrichtung 512 dazu ausgebildet, die Schalttaktung der ersten Schalter 500, 502 beim Ausschaltvorgang zeitlich vor der Schalttaktung der zweiten Schalter 504, 506 jeweils individuell zu steuern.

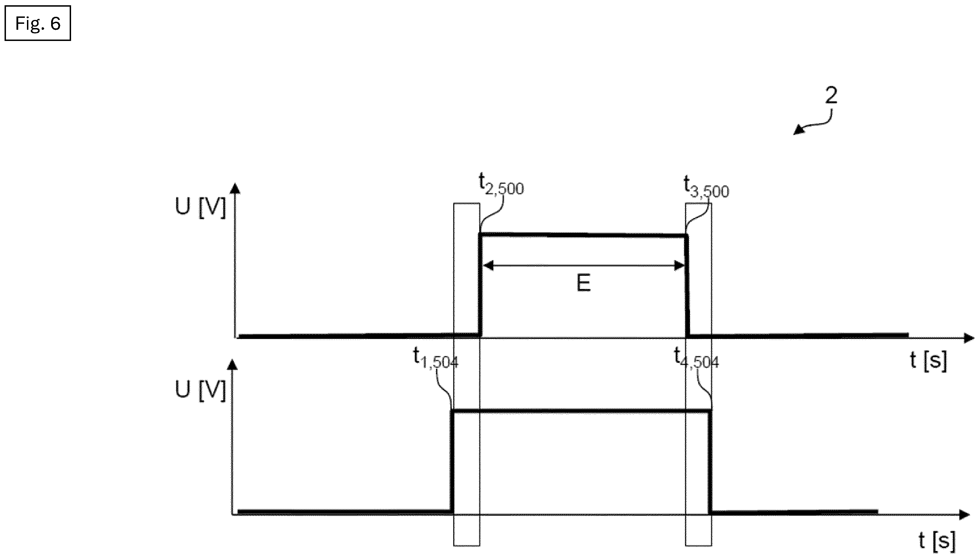

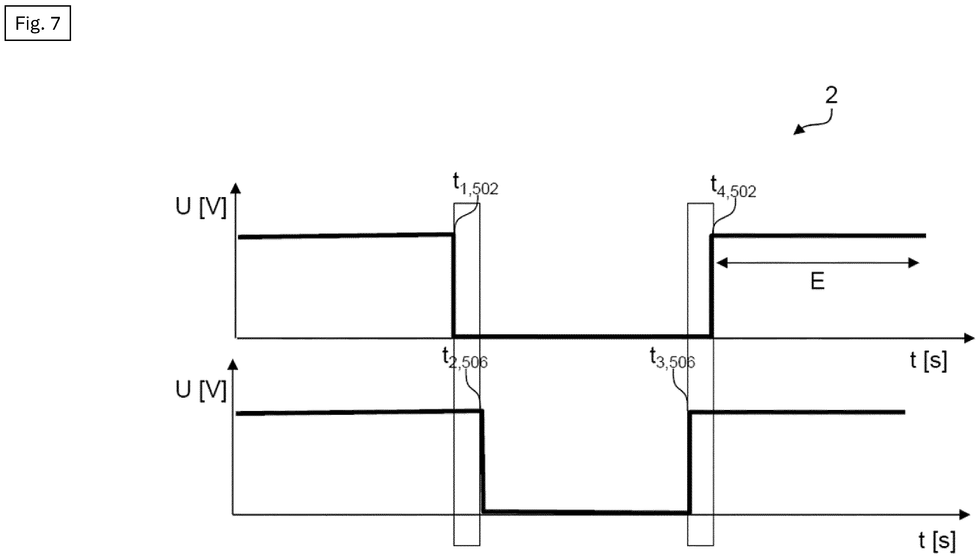

Die Schalttaktung eines Einschaltvorgangs sowie eines Ausschaltvorgangs der Schalteinrichtung 2 ist in Fig. 6 gezeigt. Bei Fig. 6 ist zuerst eine Einschaltflanke und dann eine Ausschaltflanke gezeigt. Bei Fig. 7 ist zuerst eine Ausschaltflanke und dann eine Einschaltflanke gezeigt.

Dabei ist jeweils die Spannung U der Gateansteuersignale der verschiedenen Schalter (auf der jeweiligen Abszisse) über der Zeit t (auf der jeweiligen Ordinate) aufgetragen. Beispielhaft ist dabei das zeitlich zueinander versetzte Schalten des ersten Schalters 500 und des zweiten Schalters 504 (siehe Fig. 5) auf der Highside der Halbbrücke dargestellt. Die Ausführungen gelten somit in analoger Weise für die parallel geschalteten Schalter 302, 304, wie sie in Fig. 4 (Highside-Schaltung) gezeigt sind.

Zum Einschalten wird zu einem Schaltzeitpunkt $t_{1,504}$ der Schalter 504 geschlossen bzw. durchgeschaltet, so dass ein Stromfluss durch den Schalter 504 über den Mittelabgriff 508 zumindest temporär ermöglicht ist. Zu einem Schaltzeitpunkt $t_{2,500}$, der nach dem Schaltzeitpunkt $t_{1,504}$ liegt, wird dann erst der erste Schalter 500 geschlossen bzw. durchgeschaltet. Da der erste Schalter 500 einen geringeren Leitwiderstand als der zweite Schalter 504 hat, fließt der Strom für einen verbleibenden Zeitraum eines Einschaltintervalls E verlustarm durch den Schalter 500 über den Mittelabgriff 508. Insgesamt können so die Schaltverluste als auch die Leitverluste minimiert werden.

Zum Ausschalten wird zu einem Schaltzeitpunkt $t_{3,500}$ der Schalter 500 geöffnet, so dass ein Stromfluss über den Mittelabgriff 508 durch den Schalter 504 zumindest temporär ermöglicht ist. Zu einem Schaltzeitpunkt $t_{4,504}$, der nach dem Schaltzeitpunkt $t_{3,500}$ liegt, wird dann der zweite Schalter 504 geöffnet. Da der erste Schalter 500 höhere Schaltverluste als der zweite Schalter 504 hat, wird der erste Schalter 500 vorher ausgeschaltet, um derart die Schaltverluste zu minimieren.

Die Schalttaktung eines Einschaltvorgangs sowie eines Ausschaltvorgangs der Schalteinrichtung 2 ist ferner in Fig. 7 gezeigt. Dabei ist jeweils die Spannung U der Gateansteuersignale der verschiedenen Schalter (auf der jeweiligen Abszisse) über der Zeit t (auf der jeweiligen Ordinate) aufgetragen. Beispielhaft ist dabei das zeitlich zueinander versetzte Schalten des ersten Schalters 502 und des zweiten Schalters 506 (siehe Fig. 5) auf der Lowside der Halbbrücke dargestellt. Die Ausführungen gelten somit in analoger Weise für die parallel geschalteten Schalter 302, 304, wie sie in Fig. 3 (Lowside-Schaltung) gezeigt sind.

Zunächst liegt Spannung an beiden Gateansteuersignalen an. Zum Ausschalten wird zu einem Schaltzeitpunkt $t_{1,502}$ der Schalter 502 geöffnet, so dass ein Stromfluss über den Mittelabgriff 508 durch den zweiten Schalter 506 zumindest temporär ermöglicht ist. Zu einem Schaltzeitpunkt $t_{2,506}$, der nach dem Schaltzeitpunkt $t_{1,502}$ liegt, wird dann der zweite Schalter 506 geöffnet. Da der erste Schalter 502 höhere Schaltverluste als der zweite Schalter 506 hat, wird der erste Schalter 502 vorher geöffnet, um derart die Schaltverluste zu minimieren.

Zum Einschalten wird zu einem Schaltzeitpunkt $t_{3,506}$ der zweite Schalter 506 geschlossen bzw. durchgeschaltet, so dass ein Stromfluss durch den zweiten Schalter 506 über den Mittelabgriff 508 zumindest temporär ermöglicht ist. Zu einem Schaltzeitpunkt $t_{4,502}$, der nach dem Schaltzeitpunkt $t_{3,506}$ liegt, wird dann der erste Schalter 502 geschlossen bzw. durchgeschaltet. Da der erste Schalter 502 einen geringeren Leitwiderstand hat als der zweite Schalter 506, fließt der Strom für einen verbleibenden Zeitraum eines Einschaltintervalls E verlustarm durch den ersten Schalter 502 über den Mittelabgriff 510. Insgesamt können so die Schaltverluste als auch die Leitverluste minimiert werden.

BEZUGSZEICHENLISTE

| | |
|---|---|
| 1 | Handwerkzeugmaschine |
| 2 | Schalteinrichtung |
| 4 | Aufnahmebucht |
| 5 | Hauptschalter |
| 6 | Werkzeugaufnahme |
| 7 | Bohrwerkzeug |
| 8 | Elektromotor |
| 9 | Statorwicklung |
| 10 | Rotorwicklung |
| 11 | Handgriff |
| 12 | Taster |
| 13 | Arbeitsachse |
| 14 | Leitungsanordnung |
| 15 | Anschlussterminal |
| 16 | Stecker |
| 30 | Akkueinheit |
| 31 | Zellenanordnung |
| 32 | Zellenanordnung |
| 33 | Zelle |
| 100 | Antriebseinheit |
| 300 | Spannungsquelle |
| 302 | Schalter |
| 304 | Schalter |
| 500 | Schalter |
| 502 | Schalter |
| 504 | Schalter |
| 506 | Schalter |
| 508 | Mittelabgriff |
| 510 | Mittelabgriff |
| 512 | Schaltersteuereinrichtung |
| | |
| D | Drain-Terminal |
| E | Einschaltintervall |
| G | Gate-Terminal |
| K1 | Kontakt |
| K1' | Kontakt |
| K4 | Kontakt |
| K4' | Kontakt |
| S | Source-Terminal |
| U | Gleichspannung |
| $t_{1,504}$ | Schaltzeitpunkt |
| $t_{2,500}$ | Schaltzeitpunkt |
| $t_{3,500}$ | Schaltzeitpunkt |
| $t_{4,504}$ | Schaltzeitpunkt |
| $t_{1,502}$ | Schaltzeitpunkt |
| $t_{2,506}$ | Schaltzeitpunkt |
| $t_{3,506}$ | Schaltzeitpunkt |
| $t_{4,502}$ | Schaltzeitpunkt |
| t | Zeit |

**Patentansprüche**

1. Antriebseinheit (100) für eine Handwerkzeugmaschine (1), aufweisend:

eine Spannungsquelle (300) zum Bereitstellen einer ausgangsseitigen Gleichspannung (U); einen Elektromotor (8), der durch die ausgangsseitige Gleichspannung (U) betreibbar ist; und eine Schalteinrichtung (2), die zwischen der Spannungsquelle (300) und dem Elektromotor (8) geschaltet ist, und durch die die ausgangsseitige Gleichspannung (U) zum Steuern des Elektromotors (8) schaltbar ist,

wobei die Schalteinrichtung (2) mindestens einen ersten Schalter (302, 500, 502) und einen zweiten Schalter (304, 504, 506), der parallel zu dem ersten Schalter (302, 500, 502) geschaltet ist, aufweist, wobei der erste Schalter (302, 500, 502) ein erstes Halbleitermaterial aufweist,

wobei der zweite Schalter ein zweites Halbleitermaterial aufweist, und

wobei sich das erste Halbleitermaterial von dem zweiten Halbleitermaterial unterscheidet.

2.  Antriebseinheit (100) nach Anspruch 1, wobei der erste Schalter (302, 500, 502) einen, Gate-Terminal-Transistor, insbesondere einen Metalloxid-Halbleiter-Feldeffekttransistor, aufweist, wobei der zweite Schalter (304, 504, 506) einen 3-Terminal-Transistor, insbesondere einen High-Electron-Mobility Transistor, aufweist, wobei das erste Halbleitermaterial Silizium-basiert ist, und wobei das zweite Halbleitermaterial Gallium-basiert ist.

3.  Antriebseinheit (100) nach Anspruch 1 oder 2, wobei der erste Schalter (302, 500, 502) und der zweite Schalter (304, 504, 506) der Schalteinrichtung (2) in einer Halbbrücken-Schaltung oder einer Lowside-Schaltung oder einer Highside-Schaltung umfasst sind.

4.  Antriebseinheit (100) nach einem der Ansprüche 1 bis 3, wobei die Antriebseinheit (100) ferner eine Schaltersteuereinrichtung (512) aufweist, die dazu eingerichtet ist, eine Schalttaktung zum Schalten des ersten Schalters (302, 500, 502) und eine Schalttaktung zum Schalten des zweiten Schalters (304, 504, 506) jeweils individuell zu steuern.

5.  Antriebseinheit (100) nach Anspruch 4, wobei die Schaltersteuereinrichtung (512) dazu ausgebildet ist, die Schalttaktung des zweiten Schalters (304, 504, 506) zeitlich vor der Schalttaktung des ersten Schalters (302, 500, 502) zu steuern, und/oder die Schalttaktung des ersten Schalters (302, 500, 502) zeitlich vor der Schalttaktung des zweiten Schalters (304, 504, 506) zu steuern.

6.  Antriebseinheit (100) nach einem der Ansprüche 1 bis 5, wobei das erste Halbleitermaterial einen Bandabstand bzw. eine Bandlücke von kleiner 2,0 Elektronenvolt aufweist, und wobei das zweite Halbleitermaterial einen Bandabstand bzw. eine Bandlücke von größer gleich 2,0 Elektronenvolt aufweist.

7.  Antriebseinheit (100) nach einem der Ansprüche 1 bis 6, wobei die Spannungsquelle (300) durch mindestens zwei Kontakte (K1-K4), die mit mindestens einer Akkueinheit (19, 20, 30) verbindbar sind, bereitgestellt ist.

8.  Antriebseinheit (100) nach einem der Ansprüche 1 bis 7, wobei die Spannungsquelle (300) ein Anschlussterminal (15) aufweist, das einen AC/DC-Wandler umfasst, der dazu eingerichtet ist, eine netzseitige Wechselspannung in eine Gleichspannung (U) umzuwandeln.

9.  Handwerkzeugmaschine (1) mit einer Antriebseinheit (100) nach einem der Ansprüche 1 bis 8.

10. System (1000) mit einer Handwerkzeugmaschine (1) nach Anspruch 9, einer Akkueinheit (19, 20, 30) und mit einer Ladevorrichtung zum Laden der Akkueinheit (19, 20, 30).

Fig. 1

EP 4 697 601 A1

Fig. 2

Fig. 3

Fig. 4

Fig. 5

Fig. 6

EP 4 697 601 A1

Fig. 7

Europäisches
Patentamt

European
Patent Office

Office européen
des brevets

**EUROPÄISCHER RECHERCHENBERICHT**

**Nummer der Anmeldung**

**EP 24 19 4464**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | EP 4 092 905 A1 (HILTI AG [LI]) 23. November 2022 (2022-11-23) * Abbildungen 1, 3A * * Absatz [0061] *<br>----- | 1-10 | INV. H03K17/12 H03K17/687 |
| Y | FU YONGSHENG ET AL: "A Novel Single-Gate Driver Circuit for SiC+Si Hybrid Switch With Variable Triggering Pattern", IEEE TRANSACTIONS ON POWER ELECTRONICS, INSTITUTE OF ELECTRICAL AND ELECTRONICS ENGINEERS, USA, Bd. 36, Nr. 10, 30. März 2021 (2021-03-30) , Seiten 11953-11966, XP011864064, ISSN: 0885-8993, DOI: 10.1109/TPEL.2021.3069824 [gefunden am 2021-07-01] * Zusammenfassung * * Absatz I. "INTRODUCTION" * * right column, second paragraph on page 11954 *<br>----- | 1-10 | |

**RECHERCHIERTE SACHGEBIETE (IPC)**

H03K

Der vorliegende Recherchenbericht wurde für alle Patentansprüche erstellt

| Recherchenort | Abschlußdatum der Recherche | Prüfer |
|---|---|---|
| Den Haag | 28. Januar 2025 | Simon, Volker |

KATEGORIE DER GENANNTEN DOKUMENTE

X : von besonderer Bedeutung allein betrachtet
Y : von besonderer Bedeutung in Verbindung mit einer
 anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
 nach dem Anmeldedatum veröffentlicht worden ist
D : in der Anmeldung angeführtes Dokument
L : aus anderen Gründen angeführtes Dokument
...............................................................................................
& : Mitglied der gleichen Patentfamilie, übereinstimmendes
 Dokument

EPO FORM 1503 03.82 (P04C03)

**EP 4 697 601 A1**

**ANHANG ZUM EUROPÄISCHEN RECHERCHENBERICHT
ÜBER DIE EUROPÄISCHE PATENTANMELDUNG NR.**

EP 24 19 4464

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-01-2025

| Im Recherchenbericht angeführtes Patentdokument | Datum der Veröffentlichung | Mitglied(er) der Patentfamilie | | Datum der Veröffentlichung |
|---|---|---|---|---|
| EP 4092905 A1 | 23-11-2022 | CN | 117098633 A | 21-11-2023 |
| | | EP | 4092905 A1 | 23-11-2022 |
| | | EP | 4341048 A1 | 27-03-2024 |
| | | US | 2024213894 A1 | 27-06-2024 |
| | | WO | 2022243058 A1 | 24-11-2022 |

EPO FORM P0461

Für nähere Einzelheiten zu diesem Anhang : siehe Amtsblatt des Europäischen Patentamts, Nr.12/82